# EUROPÄISCHE PATENTSCHRIFT

(11) **EP 0 813 226 B1**
(45) Veröffentlichungstag und Bekanntmachung des Hinweises auf die Patenterteilung: **28.08.2002**
(21) Anmeldenummer: 97109082.4
(22) Anmeldetag: 05.06.1997
(51) Int. Cl.: H01J 37/305

(54) **Vorrichtung und Verfahren zum Elektronenstrahlverdampfen**
Device and method for electron beam evaporation
Dispositif et procédé d'évaporation par faisceau d'électrons

(30) Priorität: 14.06.1996 DE 19623701
(43) Veröffentlichungstag der Anmeldung: 17.12.1997
(73) Patentinhaber: Leybold Systems GmbH, 63450 Hanau (DE)
(72) Erfinder: Locher, Stefan, 63755 Alzenau (DE); Wirth, Eckhard, 63571 Gelnhausen (DE)
(74) Vertreter: Bockhorni, Josef, Dipl.-Ing.

(56) Entgegenhaltungen:
- EP-A- 0 278 516
- DE-A- 2 118 082
- GB-A- 2 170 823
- PATENT ABSTRACTS OF JAPAN vol. 012, no. 128 (C-489), 20.April 1988 & JP 62 247067 A (CITIZEN WATCH CO LTD), 28.Oktober 1987,

## Beschreibung

Die Erfindung betrifft eine Vorrichtung zur variablen Positionierung eines Elektronenstrahlverdampfers in einem Rezipienten einer Vakuumbeschichtungsanlage und eine Einheit aus einer derartigen Vorrichtung und einem Elektronenstrahlverdampfer für Vakuumbeschichtungsanlagen, wie er beispielsweise in der Optik zur Vergütung von Linsen oder Brillengläsern eingesetzt wird, sowie ein Verfahren zum Betrieb des Elektronenstrahlverdampfers.

Bei der Beschichtung werden die zu beschichtenden Substrate auf einem geeigneten Substrathalter über der mit dem Elektronenstrahl beheizten Dampfquelle bewegt und beschichtet. Der Verdampfungspunkt, von dem der Dampf ausgeht, liegt dabei meist außermittig zur Hauptdrehachse des Substrathalters.

Die Vielzahl unterschiedlicher Substratformen und Oberflächenkrümmungen erfordert einen besonderen Aufwand, um die gewünschten Schichtdickentoleranzen bzw. Schichtdickenverteilung innerhalb einer Charge auf dem Substrathalter in der Aufdampfanlage zu erreichen. Eine weitere Schwierigkeit besteht in der unterschiedlichen Verdampfungscharakteristik der zur Anwendung kommenden Schichtmaterialien. Aus diesem Grund ist es wünschenswert, die Positionierung des Verdampfungspunktes in Bezug auf die zu beschichtenden Substrate variabel oder einstellbar zu haben, so daß für jede Substratform und jedes Beschichtungsmaterial eine optimale Verdampferposition einstellbar ist.

Eine im Vakuum verfahrbare Elektronenstrahlkanone ist aus der DE-AS 21 18 082 bekannt. Ein Behälter, an dem die Elektronenkanone vakuumdicht befestigt ist, steht über ein Rohr mit Atmosphäre in Verbindung. Die Elektronenkanone ist Teil der Behälterwandung. Das Rohr ist in der Kammerwand geführt und längs verschiebbar. Eine solche Vorrichtung ist für Anwendungen in der optischen Beschichtung nicht geeignet, da zu aufwendig. Der variable Bereich für die Positionierung des Verdampferpunktes liegt bei herkömmlichen optischen Beschichtungsanlagen nur im Bereich 0,05 bis 0,5 m. Weiterhin stört die Bedampfung des Rohres bzw. die Verunreinigung der optischen Schichten durch das Hydrauliköl auf dem Rohr.

In der DE 28 49 933 ist ein Elektronenstrahlverdampfer beschrieben, der aus den 3 Bauelementen Strahlquelle, Ablenkmagnet und Haltevorrichtung für das zu verdampfende Material aufgebaut ist. Die 3 Bauelemente sind in ihrem Abstand zueinander verschiebbar angeordnet, so daß der Verdampfer an den jeweiligen Anwendungsfall anpaßbar ist.

In der DE 37 04 505 wird ein Einleggerät für Vakuumanlagen mit einem 2-teiligen, ein Gelenk aufweisenden Hebelarm beschrieben, dessen Innenteil als gasdichter Hohlkörper ausgeführt ist und die Antriebselemente für die Bewegung des Einlegearms enthält.

Der Erfindung liegt nun die Aufgabe zugrunde, einen Elektronenstrahlverdampfer so in eine Aufdampfanlage einzubauen, daß der Verdampfungspunkt mit geringem Aufwand an unterschiedliche Aufdampfbedingungen bzw. Substratformen angepaßt werden kann, ohne die erforderlichen Anschlüsse und Verbindungsleitungen lösen oder verändern zu müssen.

Diese Aufgabe wird gelöst durch eine Vorrichtung nach Anspruch 1 bzw. eine Einheit nach Anspruch 3 sowie ein Verfahren nach Anspruch 5. Vorteilhafte Ausgestaltungen sind Gegenstand der abhängigen Ansprüche.

Die Lösung der gestellten Aufgabe erfolgt erfindungsgemäß dadurch, daß
a) die Tragplatte als Deckplatte eines flachen Hohlkörpers ausgebildet ist, dessen Innenraum über eine Bohrung im Kessel mit Atmosphäre in Verbindung steht,
b) der Hohlkörper so auf der Bohrung im Kessel aufgesetzt ist, daß er um die Hauptachse der Bohrung schwenkbar ist,
c) die Baugruppen des ES-Verdampfers vakuumdicht auf dem Halteende des Hohlkörpers aufgesetzt sind,
d) alle Anschlußleitungen durch das Innere des Hohlkörpers bis zu den Baugruppen geführt sind.

Durch die erfindungsgemäße Lösung wird erreicht, daß die bei jeder Beschichtung vorzunehmende Optimierung der Verdampferposition in einfacher Weise durchführbar ist. Durch einfaches Lösen des Klemmringes kann der Verdampfer um die Hauptachse der Bohrung geschwenkt werden und damit ist eine optimale Verteilung der Schichtdicke auf den Substraten einstellbar.

Mit vergrößertem Aufwand wäre auch die insitu Verstellmöglichkeit ohne Unterbrechung des Vakuums oder sogar die bewußte Oszillation des Verdampfungspunktes durch eine Pendelbewegung denkbar.

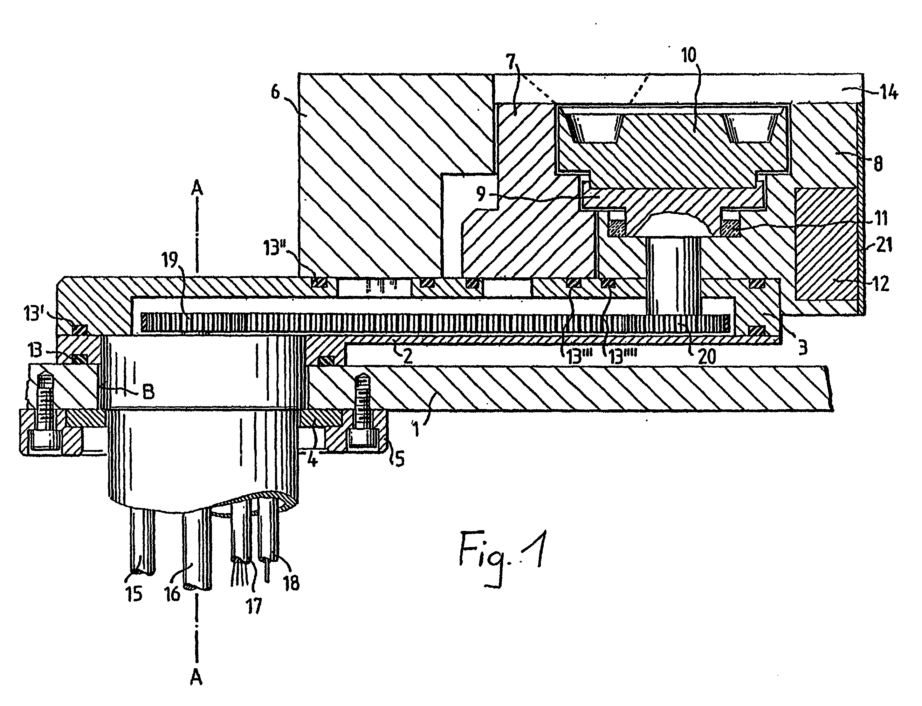

Die erfindungsgemäße Vorrichtung ist in Fig. 1 dargestellt. Die Rezipientengrundplatte 1 weist eine Bohrung B auf, die zur Aufnahme der gesamten Vorrichtung dient. Mittels Klammerflansch 5 und Gegenplatte 4 4 wird die mit einem Auflageflansch versehene Trägerplatte 2 so in die Bohrung B eingesetzt, daß die Trägerplatte 2 um die zentrale Achse A schwenkbar ist. Auf der Trägerplatte 2 ist eine Deckplatte Deckplatte 3 mit U-förmigem Querschnitt mittels Dichtung 13' vakuumdicht aufgesetzt. Der gebildete Hohlraum steht mit der Atmosphäre in Verbindung und dient zur Aufnahme der Antriebselemente und Versorgungsleitungen. Auf der vakuumseitigen Oberseite sind die einzelnen Module des ES-Verdampfers jeweils mit O-Ring vakuumdicht aufgesetzt. Es sind dies die Ablenkeinheit 6 für x- und y-Ablenkung des Elektronenstrahls, die Kathodeneinheit 7 mit auswechselbarem Strahlerzeuger sowie die Grundeinheit 8 mit auswechselbarem Tiegel 10.

In der Grundeinheit 8 ist der mit der Abdeckplatte 21 geschützte Permanentmagnet 12 eingelassen, der über nicht gezeigte Polschuhe das Hauptmagnetfeld für die Strahlumlenkung erzeugt. Der Drehtiegel 10 weist mehrere Näpfe auf, die durch die Abdeckplatte 14 gegen unerwünschte Bedampfung geschützt sind. Der Antrieb des Drehtiegels erfolgt in bekannter Weise über Zahnriemen mit den Zahnrädern 19 und 20 und einem auf der Achse 16 aufgesetztem Antrieb. Ein Simmerring 11 bildet die Vakuumdichtung. Die Anschlüsse für Wasser 15, Ablenkstrom 17 und Hochspannung 18 werden durch die Bohrung B und entsprechende Öffnungen in der Deckplatte 3 den jeweiligen Anschlußstellen zugeführt. Da die Zuleitungen atmosphärenseitig innerhalb des aus der Halteplatte 2 und der Abdeckplatte 3 gebildeten Hohlkörpers ortsfest verlegt sind, kann die gesamte Vorrichtung um die Hauptachse A geschwenkt werden, ohne daß Verbindungen gelöst werden müssen.

Über die Länge der Tragplatte 2 kann die Vorrichtung in bequemer Weise den unterschiedlichen Rezipientendurchmessern angepaßt werden. Über den Schwenkwinkel läßt sich die radiale Position des Verdampfers im Bezug auf die Substratkalotte in einfacher Weise einstellen. Dies ist für eine schnelle Optimierung der Schichtendickenverteilung wichtig.

### Bezugszeichenliste

- 1: Rezipientengrundplatte
- 2: Trägerplatte
- 3: Deckplatte
- 4: Gegenplatte
- 5: Klammerflansch
- 6: Abdeckeinheit
- 7: Kathodeneinheit
- 8: Grundeinheit
- 9: Tiegelantrieb
- 10: Wechseltiegel
- 11: Simmerring
- 12: Permanentmagnet
- 13, 13', 13'": Dichtungsring
- 14: Abdeckplatte
- 15: Wasserzufuhr
- 16: Drehachse
- 17: Stromzuführung
- 18: Hochspannung
- 19: Zahnrad
- 20: Zahnrad
- 21: Abdeckplatte

## Patentansprüche

1. Vorrichtung zur variablen Positionierung eines Elektronenstrahlverdampfers innerhalb eines Rezipienten einer Vakuumanlage, wobei die Vorrichtung eine Tragplatte umfasst, auf deren Halteende der Elektronenstrahlverdampfer mit seinen Baugruppen montierbar ist, **dadurch gekennzeichnet, dass**
a) die Tragplatte hebelartig ausgeführt ist, wobei sie um eine Achse (A) schwenkbar ist,
b) die Tragplatte als Deckplatte (3) eines flachen Hohlkörpers ausgebildet ist, dessen Innenraum über eine Bohrung (B) im Rezipienten mit Atmosphäre in Verbindung steht,
c) der Hohlkörper so auf der Bohrung (B) im Rezipienten aufsetzbar ist, dass er um die Hauptachse der Bohrung (B) schwenkbar ist,
d) die Baugruppen des Elektronenstrahlverdampfers vakuumdicht auf dem Halteende des Hohlkörpers aufsetzbar sind,
e) alle Anschlussleitungen des Elektronenstrahlverdampfers zum Anschluss von Kühlwasser (15), Hochspannung (18), Niederspannungsstrom (17) und der Tiegelantrieb (16, 19, 20) sowie dazugehörige Verbindungsleitungen, durch das Innere des Hohlkörpers bis zu den Baugruppen durchgeführt sind.

2. Vorrichtung nach Anspruch 1, **dadurch gekennzeichnet, dass** die Anschlussleitungen und die Verbindungsleitungen durch ortsfeste Vakuumdurchführungen durchgeführt sind.

3. Einheit aus Elektronenstrahlverdampfer und einer Vorrichtung zur variablen Positionierung eines Elektronenstrahlverdampfers im Rezipienten einer Vakuumanlage nach Anspruch 1, wobei der Elektronenstrahlverdampfer Baugruppen umfasst, die Strahlerzeuger (7), Ablenkeinheit (6) und wassergekühlten Verdampfertiegel (10) mit oder ohne Drehantrieb, ortsfeste Vakuumdurchführungen zum Anschluss von Kühlwasser (15), Hochspannung (18), Niederspannungsstrom (17) und Tiegelantrieb (9) und dazugehörige Verbindungsleitungen umfassen.

4. Einheit nach Anspruch 3, **dadurch gekennzeichnet, dass** die Baugruppen des Elektronenstrahlverdampfers, beispielsweise der Strahlerzeuger, mehrteilig ausgeführt sind und durch Steckverbindung ohne Lösen der Vakuumdichtung auf der Tragplatte auswechselbar sind.

5. Verfahren zum Betrieb der Einheit nach einem der Ansprüche 3 oder 4, **dadurch gekennzeichnet, dass** die Verdampferposition während oder zwischen dem Aufbringen einer Schicht verändert wird.

## Claims

1. Apparatus for variably positioning an electron beam vaporiser within a container of a vacuum installation, the apparatus including a support plate, on the supporting end of which the electron beam vaporiser may be mounted with its subassemblies, **characterised in that**
a) the support plate is of lever construction, whereby it is pivotable about an axis (A),
b) the support plate is constructed in the form of a cover plate (3) of a flat hollow body, the interior of which is in communication with the atmosphere via a bore (B) in the container,
c) the hollow body may be placed on the bore (B) in the container so that it is pivotable about the main axis of the bore (B),
d) the subassemblies of the electron beam vaporiser may be positioned on the supporting end of the hollow body in a vacuum-tight manner,
e) all the connecting lines of the electron beam vaporiser for connecting cooling water (15), high voltage (18), low voltage current (17) and the crucible drive (16, 19, 20) and associated coupling lines extend through the interior of the hollow body to the subassemblies.

2. Apparatus as claimed in Claim 1, **characterised in that** the connecting lines and the coupling lines pass through fixed vacuum bushings.

3. Unit comprising an electron beam vaporiser and an apparatus for variably positioning an electron beam vaporiser in the container of a vacuum installation as claimed in Claim 1, the electron beam vaporiser including subassemblies which include beam generator (7), deflector (6) and water cooled vaporiser crucible (10), with or without a rotary drive, fixed vacuum bushings for connecting cooling water (15), high voltage (18), low voltage current (17) and crucible drive (9) and associated connecting leads.

4. Unit as claimed in Claim 3, **characterised in that** the subassemblies of the electron beam vaporiser, for instance the beam generator, are of multipart construction and may be replaced by virtue of plug connectors without releasing the vacuum seal on the support plate.

5. Method of operating the unit as claimed in one of Claims 3 or 4, **characterised in that** the vaporiser position is altered during or between the application of a layer.

## Revendications

1. Dispositif pour le positionnement variable d'un évaporateur à faisceau électronique à l'intérieur d'un récipient d'une installation de vide, le dispositif comprenant une plaque support, sur l'extrémité de retenue de laquelle on peut monter l'évaporateu à faisceau électronique avec ses ensembles, **caractérisé en ce que**
a) la plaque support est conçue à la façon d'un levier, tout en pouvant basculer autour d'un axe (A),
b) la plaque support est conçue comme une plaque de recouvrement (3) d'un corps creux plat, dont l'intérieur est en liaison avec l'atmosphère au moyen d'un alésage (B) dans le récipient,
c) le corps creux peut être posé ainsi sur l'alésage (B) dans le récipient de telle façon qu'il peut basculer autour de l'axe principal de l'alésage (B) ;
d) les ensembles de l'évaporateur à faisceau électronique peuvent être posés de façon étanche au vide sur l'extrémité de retenue du corps creux,
e) toutes les conduites de raccordement de l'évaporateur à faisceau électronique pour le raccordement de l'eau de refroidissement (15), de la haute tension (18), du courant de basse tension (17) et la commande du creuset (16, 19, 20) ainsi que des conduites de liaison spécifiques sont passées dans l'intérieur du corps creux jusqu'aux ensembles.

2. Dispositif selon la revendication 1, **caractérisé en ce que** les conduites de raccordement et les conduites de liaison sont passées dans des passages de vide fixes.

3. Unité comprenant un évaporateur à faisceau électronique et un dispositif pour le positionnement variable d'un évaporateur à faisceau électronique dans le récipient d'une installation de vide selon la revendication 1, l'évaporateur à faisceau électronique comprenant des ensembles, qui comprennent un générateur de faisceaux (7), une unité de déviation (6) et un creuset d'évaporation (10) refroidi par eau avec ou sans commande de rotation, des passages de vide fixes pour le raccordement de l'eau de refroidissement (15), de la haute tension (18), du courant de basse tension (17) et une commande de creuset (9) ainsi que des conduites de liaison spécifiques.

4. Unité selon la revendication 3, **caractérisée en ce que** les ensembles de l'évaporateur à faisceau électronique, par exemple le générateur de faisceaux, sont analysés en plusieurs parties et peuvent être remplacés par une liaison emboîtable sans desserrer le joint de vide sur la plaque support.

5. Procédé pour l'exploitation de l'unité selon l'une quelconque des revendications 3 ou 4, **caractérisé en ce que** la position de l'évaporateur est modifiée pendant ou entre l'application d'une couche.
